# EUROPÄISCHE PATENTSCHRIFT

(11) **EP 3 984 102 B1**
(45) Veröffentlichungstag und Bekanntmachung des Hinweises auf die Patenterteilung: **19.02.2025**
(21) Anmeldenummer: 19752992.8
(22) Anmeldetag: 02.08.2019
(51) Int. Cl.: H02B 13/035, G01R 31/12, H02B 13/065, H02G 5/06, G01R 29/08

(54) **VERBINDUNGSSTRUKTUR MIT UHF-ANTENNE FÜR EINE GASISOLIERTE SCHALTANLAGE**
CONNECTION STRCTURE WITH UHF ANTENNA FOR A GAS INSULATED SWITCHGEAR
STRUCTURE DE CONNEXION AVEC ANTENNE UHF POUR APPAREILLAGE À ISOLATION GAZEUSE

(43) Veröffentlichungstag der Anmeldung: 20.04.2022
(73) Patentinhaber: Siemens Energy Global GmbH & Co. KG, 81739 München (DE)
(72) Erfinder: TSAGUE, Armand, 90451 Nürnberg (DE); WIEDENBAUER, Anton, 91809 Wellheim (DE)
(86) Internationale Anmeldenummer: PCT/EP2019/070934
(87) Internationale Veröffentlichungsnummer: WO 2021/023363

(56) Entgegenhaltungen:
- WO-A1-2007/097491
- FR-A1- 3 015 043
- JP-A- H10 341 520
- JP-A- H11 122 761
- JP-A- S6 356 112
- JP-B2- 4 936 846
- US-A1- 2011 005 809

## Beschreibung

### GEBIET DER ERFINDUNG

Die vorliegende Erfindung betrifft eine Verbindungsstruktur zum Verbinden zweier Gehäuseteile einer gasisolierten Schaltanlage, betrifft eine gasisolierte Schaltanlage, betrifft ferner ein Herstellungsverfahren bzw. Nachrüstungsverfahren einer Verbindungsstruktur zum Verbinden zweier Gehäuseteile einer gasisolierten Schaltanlage und betrifft ferner ein Verfahren eines Überwachens einer gasisolierten Schaltanlage.

### STAND DER TECHNIK

Eine gasisolierte Schaltanlage (GIS) ist eine vollständig gasdicht gekapselte Schaltanlage für Hochspannung und Mittelspannung, die zur Isolierung den oder die elektrischen Leiter mit Schwefelhexafluorid (SF₆) als Schutzgas umgibt. Damit sind kompakte Schaltanlagen in engen Räumen realisierbar. SF₆ hat eine drei- bis vierfach höhere Durchschlagsfestigkeit als Luft bei Normaldruck.

Im Falle eines Fehlers im Inneren der Schaltanlage kann es zu einem Störlichtbogen kommen, allgemein zu einer Gasentladung. Dabei können sehr hohe Überdrücke und Erwärmungen auftreten, welche die Schaltanlage mechanisch und/oder thermisch beanspruchen und unter Umständen zerstören können. Insbesondere können Teilentladungen (TE) in gasisolierten Schaltanlagen (GIS) elektromagnetische Wellen mit Frequenzen im Ultrahochfrequenz-(UHF)-Bereich erzeugen. Diese UHF-Wellen können für Überwachungs- und Diagnosezwecke detektiert und analysiert werden. Unter der Bedingung, dass UHF-Sensoren am GIS vorhanden sind, kann somit eine Überwachung leicht durchgeführt werden.

Aus der Schrift JP H11 122761 A ist eine gasisolierte Schaltanlage bekannt, bei der zur Detektion solcher elektromagnetischer Wellen ein isolierender Abstandshalter aus einem Gießharz verwendet wird. Um die elektromagnetischen Wellen aus der Schaltanlage zur Oberfläche des Abstandshalters herauszuleiten, wird ein Wellenleiter aus einem Material mit einer im Vergleich zu dem Gießharz niedrigeren Dielektrizitätskonstante verwendet. Auf der Oberfläche des Abstandshalters ist eine ringförmige Antenne angeordnet, die das Ende des Wellenleiters umschließt.

Die Schrift JP 4 936846 B2 offenbart ein Isolierstück, das einen integrierten Schaltkreis mit einem Sensor aufweist. Der Sensor dient zum Erkennen von Teilentladungen.

Aus der Schrift JP H10 341520 A ist es bekannt, die bei Teilentladungen entstehenden Mikrowellen mittels eines Wellenleiters zu einer Antenne eines Mikrowellensensors zu leiten und mittels dieser Antenne zu empfangen.

Die Schrift US 2011/005809 A1 offenbart ein rotationssymmetrisches Isolierteil für eine gasisolierte Anlage, das eine Öffnung zum Einfüllen von Gießharz aufweist.

Die Schriften WO 2007/097491 A1 und FR 3 015 043 A1 offenbaren ebenfalls UHF-Sensoren, die an einer radialen Öffnung einer gasisolierten Anlage angeordnet sind.

Die Schrift FR 3 015 043 A1 offenbart eine Verbindungsstruktur einer gasisolierten Schaltanlage mit einem Flansch-Ring der sich am Außenrande eines Isolierteils abstützt. Der Flansch-Ring weist eine Öffnung auf, in der ein UHF-Sensor mit Sensorelektrode und elektrischem Anschluss montiert ist. Der Flansch-Ring ist jedoch nicht mit dem Isolierteil vergossen.

Herkömmlicherweise sind jedoch gasisolierte Schaltanlagen nur unzureichend mit UHF-Sensoren ausgestattet. Auch eine Nachrüstung der UHF-Sensoren ist nicht in allen Situationen möglich, oder nur bei Abschaltung der gesamten Anlage ermöglicht. Insbesondere sind Viewports nicht immer an der GIS vorhanden bzw. deren Anzahl ist sehr begrenzt. Ferner hat sich herausgestellt, dass die Empfindlichkeit eines an einem Viewport platzierten UHF-Sensors sehr gering ist. Grundsätzlich können UHF-Antennen nicht an Flanschen mit metallischen Ringen angebracht werden, da bei einer derartigen Platzierung die elektromagnetischen Wellen nicht durch Metalle hindurchtreten und so nicht detektiert werden können. Herkömmlicherweise wurden gasisolierte Schaltanlagen nachgerüstet, was jedoch eine Abschaltung der Anlage erforderte, oder SF₆-Gasarbeiten und neu spezifisch angefertigte Komponenten erforderte.

Somit ist es eine Aufgabe der vorliegenden Erfindung Vorrichtungen und Verfahren bereitzustellen, welche ermöglichen, die GIS zu überwachen, insbesondere einen UHF-Sensor bzw. eine UHF-Antenne derart an einem GIS anzubringen, dass die Erfassung von elektromagnetischen Wellen aufgrund von einer Teilentladung ermöglicht ist.

Die Aufgabe wird durch die Gegenstände der unabhängigen Ansprüche gelöst. Die abhängigen Ansprüche spezifizieren insbesondere Ausführungsformen der vorliegenden Erfindung.

### ZUSAMMENFASSUNG DER ERFINDUNG

Gemäß der vorliegenden Erfindung ist eine Verbindungsstruktur gemäß Anspruch 1 zum Verbinden zweier Bausteine (auch als Anlagenteile bezeichnet) einer gasisolierten Schaltanlage bereitgestellt, aufweisend unter anderem: einen metallischen Flansch-Ring; eine Gießharzeingussöffnung in dem Flansch-Ring; und einen UHF-Sensor mit Antenne, der bei der Gießharzeingussöffnung montiert ist.

Die gasisolierte Schaltanlage (GIS) kann mehrere Anlagenbausteine (auch als Anlagenteile bezeichnet) umfassen, wobei in jedem der Anlagenteile ein Stromleiter oder eine elektrische Komponente, wie etwa ein Spannungswandler, ein Stromwandler, ein Trenner, eine Unterbrechereinheit, ein Erder oder ähnliches angeordnet sein kann. Eine in einem ersten Anlagenteil befindliche elektrische Komponente kann erfordert sein, mit einer zweiten elektrischen Komponente, welche sich in einem zweiten Anlagenteil befindet, verbunden zu werden bzw. zu sein. Dazu kann die Verbindungsstruktur verwendet werden, die herkömmlicherweise auch als "Durchführung" bezeichnet werden kann. Die Verbindungsstruktur verbindet einerseits mechanisch die beiden Anlagenteile miteinander und ermöglicht ferner eine elektrische Verbindung der ersten in dem ersten Anlagenteil befindlichen elektrischen Komponente mit der in dem zweiten Anlagenteil befindlichen zweiten elektrischen Komponente. Somit weist jedes der Anlagenteile eine Außenwand auf, insbesondere metallische Außenwand, und ein von der Außenwand umgebenden Innenraum, in welchem die eine oder mehrere elektrische Komponenten angeordnet sind.

Eine Verbindungsstruktur (Durchführung) bestehend aus einem Flanschring, einem Gießharzkörper und einer oder drei Elektroden ist vorgesehen, um zwei Anlagenteile mechanisch und elektrisch miteinander zu verbinden, wobei dabei eine gasdichte Verbindung erreicht werden muss. Der Gießharzkörper ist in den Flanschring (z.B. aus Metall) und die Elektrode ist in den Gießharzkörper eingegossen. Die gasisolierte Schaltanlage ist im Betrieb mit einem Gas gefüllt (im Allgemeinen mit SF₆) und ist für Spannungen von über 500 kV ausgelegt.

An dem Flanschring kann herkömmlicherweise ein Stopfen (auch als Deckel bezeichnet) vorgesehen sein, der beim Öffnen einen direkten Kontakt zum Gießharz ermöglicht, da dieses vom Flanschring umschlossen ist.

Das Stopfen dient somit herkömmlicherweise zum Schließen der Gießharzeingussöffnung und weist einen kreisförmigen Querschnitt auf. Die Gießharzeingussöffnung kann somit von außen bei vollmontierter gasisolierter Schaltanlage zugänglich sein.

Die Verbindungsstruktur kann in einem separaten Herstellungsprozess bzw. Nachrüstungsprozess hergestellt bzw. nachgerüstet werden, gemäß Ausführungsform der vorliegenden Erfindung. Das Nachrüsten kann z.B. Ersetzen des Stopfens (Deckels) durch einen UHF-Sensor umfassen. Der UHF-Sensor umfasst zumindest die UHF-Antenne und kann zusätzlich ein Schließund Dichtungsfunktion haben, um die Eingussöffnung (ähnlich wie der konventionelle Stopfen/Deckel) zu verschließen.

Teilentladungen sind nach IEC 60270 lokale elektrische Entladungen, die die Isolierung zwischen Leitern nur teilweise überbrücken. Sie sind meist Folge einer Übererhöhung von der lokalen elektrischen Feldstärke innerhalb der Isolationsmaterial (liquid, fest oder gasförmig) oder auf der Oberfläche der Isolation oder eines Leiters.

Teilentladungen sind Folgen eines Defekts oder Unreinheit innerhalb der GIS und erzeugen elektromagnetischen Wellen, die sich dann ausbreiten. Diese elektromagnetischen Wellen haben Frequenzen in UHF (Ultra-Hoch-Frequenz) Bereich und können mithilfe von UHF-Sonden oder -Antennen erfasst werden.

Die UHF-Sonden können intern oder extern angebracht werden. Die interne Ausführung soll am besten während der Herstellung der GIS angebracht werden, da die Nachrüstung mit hohen Kosten verknüpft ist.

Die externe Ausführung am Flanschring ist nur möglich, wenn dieser nicht metallisch ist. Sie ist genauso wie die Ausführung am Viewport störanfälliger.

Durch die Gießharzeingussöffnung kann eine UHF-Antenne derart montiert sein, dass sie zumindest teilweise in einen Innenraum hineinragt; Somit ist eine bequeme Möglichkeit gegeben, eine UHF-Antenne für Überwachungs- und Diagnosezwecke zu montieren bzw. zu verwenden.

Gemäß einer Ausführungsform der vorliegenden Erfindung ist die UHF-Antenne derart montiert, dass innerhalb der GIS vorhandene elektromagnetische Wellen erfassbar werden können. Die elektromagnetischen Wellen, verursacht durch Teilentladungen, verbreiten sich in dem Innenraum der gasisolierten Schaltanlage, so dass sie auch innerhalb des Gießharzes vorhanden sein können. Somit ist eine einfache Überwachung der gasisolierten Schaltanlage ermöglicht.

Gemäß einer Ausführungsform der vorliegenden Erfindung führt die Gießharzeingussöffnung durch eine Mantelfläche des Flansch-Ringes. An dieser Mantelfläche können herkömmlicherweise Gießharzeingussöffnungen vorhanden sein. Während eines Eingießens des Gießharzes durch die Gießharzeingussöffnung können Stirnseiten des Flansch-Ringes durch Platten (oder Eingussformen) verschlossen sein.

Im vom Flanschring umgebenen Raum kann eine (oder mehrere je nach Anzahl der elektrischen Phasen) Verbindungselektrode vorgesehen sein, welche von dem Gießharz umgeben wird und nach Aushärten mechanisch fixiert wird. Die Verbindungselektrode (oder allgemein elektrische Verbindungsstruktur) kann ermöglichen, dass ein erster Leiter aus einem ersten Anlagenteil der GIS mit einem zweiten Leiter in einem zweiten Anlagenteil der GIS insbesondere elektrisch verbindbar ist.

Die UHF-Antenne ist derart montiert, dass sie in Kontakt mit dem (ausgehärteten) Gießharzmaterial ist. Das Gießharzmaterial kann ein dielektrisches Material, insbesondere nichtleitfähiges Material aufweisen. Insbesondere können sich elektromagnetische Wellen innerhalb des Gießharzmaterials mit einer geringeren Dämpfung ausbreiten. Damit kann sich eine innerhalb des GIS-Innenraums vorhandene elektromagnetische Welle auch durch das Gießharzmaterial hindurch ausbreiten und von der UHF-Antenne erfasst werden.

Das Gießharzmaterial kann gasundurchlässig sein, um eine gasundurchlässige Verbindungsstruktur zu bilden.

In Ausführungsformen wird zunächst das Gießharzmaterial eingegossen, ohne die UHF-Antenne mit zu umgeben. Erst nach Aushärtung des Gießharzmaterials kann der UHF-Sensor mit der UHF-Antenne geeignet montiert werden. Dazu weist der UHF-Sensor einen Montageabschnitt und einen damit verbundenen Schließabschnitt auf. Der Montageabschnitt ermöglicht eine Montage an dem Flansch-Ring, wobei der Schließabschnitt die Eingussöffnung verschließt. Die UHF-Antenne ist an dem Schließabschnitt befestigt, der z.B. eine Funktion eines Deckels hat.

Der UHF-Sensor kann durch Verschrauben des Montageabschnitts in vorhandenen Löchern um die Eingussöffnung herum an dem Flansch-Ring montiert werden.

Gemäß einer Ausführungsform der vorliegenden Erfindung weist der Deckel eine Leiterdurchführung auf, durch die ein von der UHF-Antenne erfasstes Antennen-Signal nach außen abführbar ist. Generell kann der Deckel aus einem Metall gefertigt werden, etwa Stahl. Die Leiterdurchführung kann isoliert durch das metallische Material des Deckels geführt werden. Die Leiterdurchführung kann z.B. zweipolig ausgeführt sein. Somit ist ein leichtes Nachaußenführen des elektrischen Antennen-Signals ermöglicht.

Erfindungsgemäß weist der UHF-Sensor an der Außenseite einen elektrischen Anschluss (N-Stecker oder BNC Stecker) auf, der mit dem Kopf der UHF-Antenne elektrisch verbunden ist. Nur bei Bedarf kann an dem Anschluss, mithilfe eines Koaxialkabels, ein Teilentladungsmessgerät verbunden werden. Im Fall der Nichtbenutzung wird die Antenne durch eine Schutzkappe am Steckeranschluss kurzgeschlossen. Nicht in jedem Fall muss eine Überwachung durchgeführt werden. Damit kann große Flexibilität erreicht werden.

Gemäß einer Ausführungsform der vorliegenden Erfindung weist der Schließabschnitt des UHF-Sensors und/oder ein die Gießharzeingussöffnung begrenzender Rand des Flansch-Ringes eine Dichtung auf, welche insbesondere dicht für SF₆ ist. Damit können herkömmlicherweise mit SF₆ gefüllte gasisolierte Schaltanlagen unterstützt werden.

Gemäß einer Ausführungsform der vorliegenden Erfindung ist der Flansch-Ring im Wesentlichen kreiszylinderförmig. Damit können herkömmliche Verbindungsstrukturen unterstützt werden, und herkömmliche Flansche von GIS-Anlageteilen können mit dem Flansch-Ring verbunden werden.

Gemäß einer Ausführungsform der vorliegenden Erfindung weist der Flansch-Ring Löcher entlang eines Umfanges auf, um an jeder der beiden Stirnseiten (des Flansch-Ringes) ein jeweiliges Anlagenteil der GIS mittels Schrauben und/oder Bolzen anbringen zu können, wobei die Anbringung insbesondere gasdicht erfolgen kann. Damit kann eine herkömmliche Verbindungstechnik zur Verbindung zwischen dem Flansch-Ring und einem Anlagenteil unterstützt werden.

Gemäß einer Ausführungsform der vorliegenden Erfindung ist die UHF-Antenne zum Empfangen einer elektromagnetischen Welle ausgelöst durch eine Gasentladung bzw. Funkenbildung, insbesondere mit Frequenz zwischen 100 MHz und 2 GHz ausgelegt. Damit kann eine effektive Überwachung der GIS erreicht werden.

Gemäß einer Ausführungsform der vorliegenden Erfindung ist eine gasisolierte Schaltanlage bereitgestellt, aufweisend ein erstes Anlagenteil und ein zweites Anlagenteil und eine Verbindungsstruktur (herkömmlich auch als "Durchführung" bezeichnet) gemäß einer der vorangehenden Ausführungsformen, die an einer ersten Stirnseite mit dem ersten Anlagenteil und an einer zweiten Stirnseite mit dem zweiten Anlagenteil verbunden ist.

Die GIS kann weitere Anlageteile mit weiteren elektrischen Komponenten darin aufweisen. Insbesondere können mehrere Verbindungsstrukturen gemäß Ausführungsformen der vorliegenden Erfindung vorgesehen sein, um eine Überwachung an verschiedenen Stellen der GIS zu ermöglichen.

Es sollte verstanden werden, dass Merkmale, welche individuell oder in irgendeiner Kombination im Zusammenhang mit einer Verbindungsstruktur zur Verbindung zweier Anlagenteile einer gasisolierten Schaltanlage beschrieben, bereitgestellt oder erläutert worden sind, ebenso, individuell oder in irgendeiner Kombination, für ein Verfahren eines Herstellens oder eines Nachrüstens bzw. für ein Verfahren eines Überwachens einer GIS anwendbar sind, gemäß Ausführungsformen der vorliegenden Erfindung und umgekehrt.

Gemäß einer Ausführungsform der vorliegenden Erfindung ist ein Verfahren eines Herstellens und/oder Nachrüstens einer Verbindungsstruktur zum Verbinden zweier Anlagenteile einer gasisolierten Schaltanlage bereitgestellt, aufweisend Montieren eines UHF-Sensors bei einer Gießharzeingussöffnung eines metallischen Flansch-Ringes der Verbindungsstruktur.

Gemäß einer Ausführungsform der vorliegenden Erfindung ist ein Verfahren eines Überwachens einer gasisolierten Schaltanlage bereitgestellt, aufweisend Verwenden eines bei einer Gießharzeingussöffnung eines metallischen Flansch-Ringes einer zwei Anlagenteile der GIS verbindenden Verbindungsstruktur montierten UHF-Sensors mit UHF-Antenne und Erfassen einer innerhalb der GIS erzeugten elektromagnetischen Welle mittels der UHF-Antenne.

Ausführungsformen der vorliegenden Erfindung werden nun mit Bezug auf die beiliegenden Zeichnungen beschrieben. Die Erfindung ist nicht auf die illustrierten oder beschriebenen Ausführungsformen beschränkt.

### KURZE BESCHREIBUNG DER ZEICHNUNGEN

Fig. 1 illustriert schematisch eine gasisolierte Schaltanlage (Type 8DN9) gemäß einer Ausführungsform der vorliegenden Erfindung;
Fig. 2 illustriert einen Teil der in Fig. 1 gezeigten GIS, wobei eine Verbindungsstruktur ("Durchführung") gemäß einer Ausführungsform der vorliegenden Erfindung illustriert ist;
Fig. 3 illustriert einen Teil einer Verbindungsstruktur gemäß einer Ausführungsform der vorliegenden Erfindung einschließlich einer Gießharzeingussöffnung;
Fig. 4 illustriert schematisch eine Querschnittsansicht einer Verbindungsstruktur (Durchführung) mit eingebautem UHF-Sensor gemäß einer Ausführungsform der vorliegenden Erfindung; und
Fig. 5 illustriert eine Detailansicht der Fig. 4.

### DETAILLIERTE BESCHREIBUNG VON AUSFÜHRUNGSFORMEN

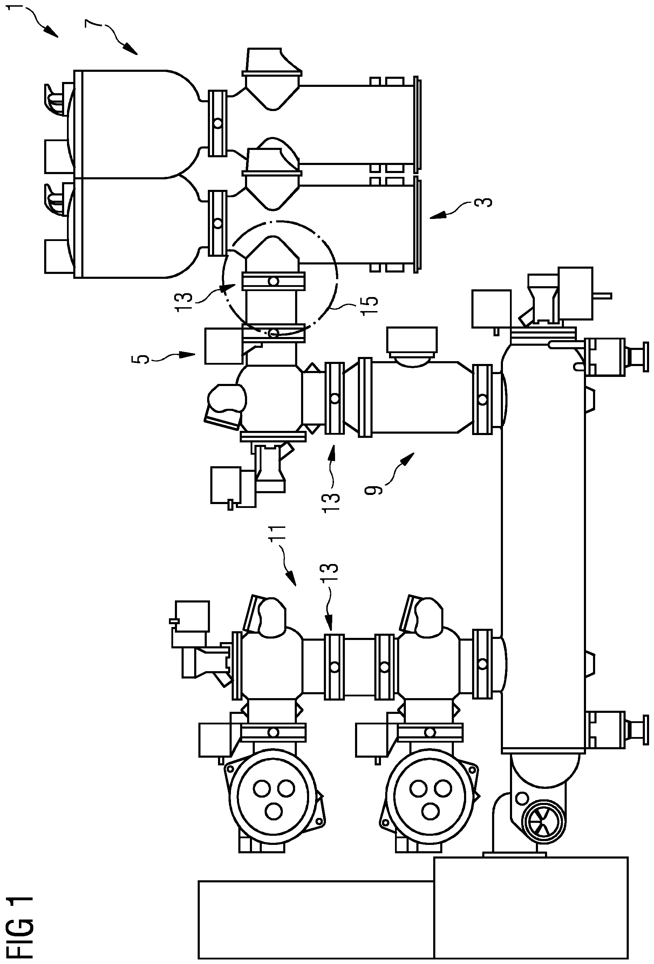

Die schematisch in Fig. 1 illustrierte gasisolierte Schaltanlage (GIS) 1 gemäß einer Ausführungsform der vorliegenden Erfindung umfasst ein erstes Anlagenteil 3 und ein zweites Anlagenteil 5, welche beide entsprechende Außenwände und einen entsprechenden Innenraum aufweisen, in dem eine erste elektrische Komponente bzw. eine zweite elektrische Komponente (nicht illustriert) angeordnet sind. Die GIS 1 weist weitere Anlagenteile 7, 9, 11 auf, welche mit dem ersten Anlagenteil 3 bzw. dem zweiten Anlagenteil 5 verbunden sind.

Eine Verbindungsstruktur 13 gemäß der vorliegenden Erfindung ist vorgesehen, um das erste Anlagenteil 3 mit dem zweiten Anlagenteil 5 zu verbinden. Insbesondere weist die in Fig. 1 illustrierte GIS weitere Verbindungsstrukturen 13 gemäß Ausführungsformen der vorliegenden Erfindung auf, wobei jede dieser Verbindungsstrukturen 13 einen entsprechenden UHF-Sensor mit UHF-Antenne aufweist, um elektrische Wellen, die innerhalb der GIS 1 erzeugt sind, detektieren zu können.

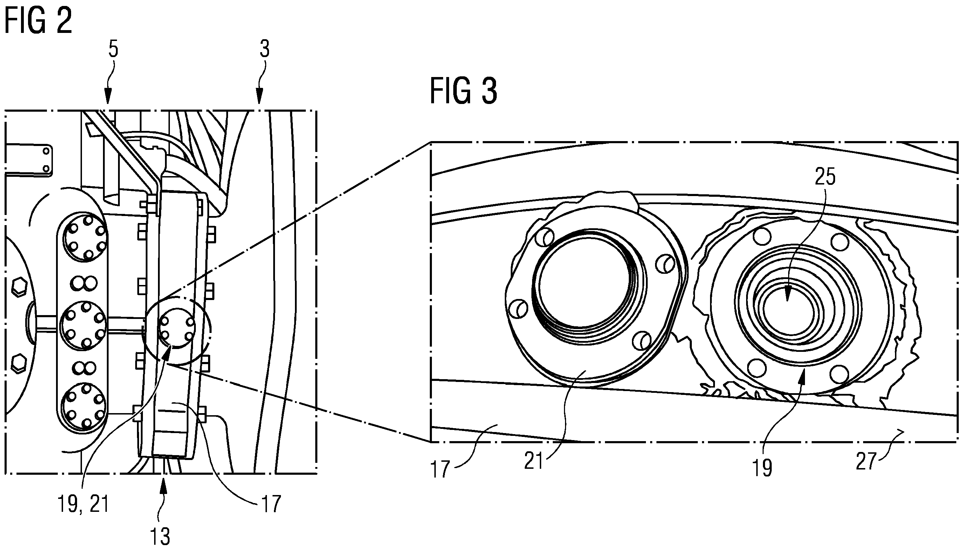

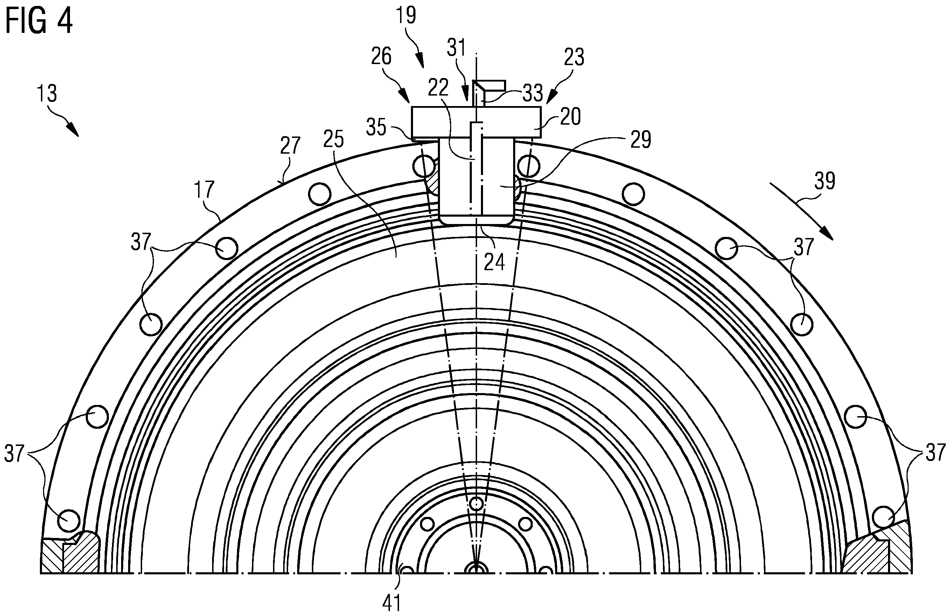

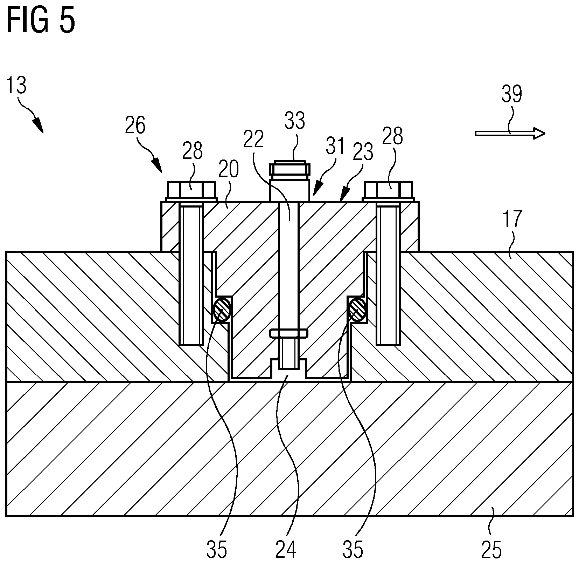

Der Kreisausschnitt 15, welcher die Verbindungsstruktur 13 enthält, ist in Fig. 2 illustriert. Die Verbindungsstruktur 13 weist dabei einen metallischen Flansch-Ring 17 auf, sowie eine Gießharzeingussöffnung 19, welche in Fig. 2 durch einen Deckel 21 verschlossen ist. Die Verbindungsstruktur 13 weist ferner einen in Fig. 2 und Fig. 3 nicht illustrierten Anlagenteil 23 mit UHF-Antenne 22, 24 auf, welche z.B. in Fig. 4 und 5 illustriert ist.

Fig. 3 illustriert den Ausschnitt 16 der Fig. 2, insbesondere in größerem Detail die Gießharzeingussöffnung 19, während der Deckel 21 abgenommen ist. Dabei ist ein Gießharzmaterial 25 erkennbar, welches innerhalb des Flansch-Ringes 17 angeordnet und dort ausgehärtet ist. Die UHF-Antenne 23 kann in Kontakt mit dem Gießharz 25 sein. Wie in Fig. 3 ersichtlich ist, ist die Gießharzeingussöffnung 19 durch eine Mantelfläche 27 des Flansch-Ringes geführt.

Fign. 4, 5 illustrieren in schematischer Darstellung eine Übersichts-Schnittansicht bzw. Detailschnittansicht der Verbindungsstruktur 13, wobei die Zeichenebene parallel zu einer Stirnfläche des Flansch-Ringes 17 liegt. Innerhalb des Flansch-Ringes 17 ist das Gießharz 25 durch die Gießharzeingussöffnung 19 eingefüllt worden.

Der herkömmlicherweise vorhandene Deckel 21 ist abgenommen und stattdessen ein UHF-Sensor 23 an dem Flansch-Ring montiert.

Der UHF-Sensor 23 mit Antenne ist so gebaut, dass er in der Eingussöffnung 19 passt. Er weist am Ende eine Sensorelektrode 24 auf; diese wird dann durch eine leitfähige Achse 22 zum Anschluss 33 geführt. Der Montageabschnitt 26 des UHF-Sensors 23 ist mit Schrauben 28 in Gewindelöcher an die Mantelfläche 27 der Flansches 17 geschraubt. Der Schließabschnitt 20 des UHF-Sensors 23 trägt die UHF-Antenne 22, 24 und verschließt gleichzeitig die Eingussöffnung 19. Die UHF-Antenne (22, unfasst Sensorelektrode 24 an einem radial inneren Ende, welche sensitiv für elektromagnetische Wellen ist.

Der Schließabschnitt 20 weist eine Leiterdurchführung 31 auf, durch die ein von der UHF-Antenne 22, 24 erfasstes AntennenSignal nach außen abführbar ist. Auch weist der Schließabschnitt 20 an einer Außenseite einen elektrischen Anschluss 33 auf, der mit der UHF-Antenne 22, 24 elektrisch verbunden ist.

Ferner ist eine Dichtung 35 zwischen dem UHF-Sensor 23 und dem Flansch-Ring 17 vorgesehen, wie aus Fig. 5 ersichtlich ist.

Wie aus Fig. 4 ersichtlich ist, hat der Flansch-Ring eine Kreiszylinderform. Ferner weist der Flansch-Ring 17 Löcher 37 entlang eines Umfanges 39 auf. Damit kann jede der beiden Stirnseiten des Flansch-Ringes 17 mit dem ersten Anlagenteil 3 bzw. dem zweiten Anlagenteil 5 mechanisch verbunden werden, etwa mittels Schrauben und/oder Bolzen.

Im Zentrum des Flansch-Ringes ist mindestens eine (für drei Phasen drei) elektrische Verbindungselektrode 41 vorgesehen, mittels derer ein erster Leiter (oder eine erste elektrische Komponente) in dem ersten Anlagenteil 3 mit einem zweiten Leiter (oder einer zweiten elektrischen Komponente) in dem zweiten Anlagenteil 5 verbindbar ist. Die Verbindungselektrode 41 ist z.B. in dem Gießharz 25 eingegossen.

Eingussöffnungen, wie etwa die Eingussöffnung 19, können an vielen Stellen der GIS vorhanden sein. Diese Öffnungen können einen direkten Kontakt zur Gießharzisolierung erlauben. An diesen Öffnungen werden gemäß Ausführungsformen der vorliegenden Erfindung speziell gefertigte UHF-Sensoren platziert. Dabei sind für den Anbau bzw. die Nachrüstung am GIS keine SF₆-Gasarbeiten erforderlich, ebenso wenig eine Abschaltung der Anlage.

Wesentliche Vorteile gemäß Ausführungsformen der vorliegenden Erfindung ergeben sich bei der Installierung bzw. Nachrüstung. Dabei werden keine zusätzlichen Arbeiten an den GIS durchgeführt. Bei der Anbringung ist keine Abschaltung der Anlage erforderlich, deswegen die Installation insgesamt billiger ist. Ferner sollte das Signal zu Rauschverhältnis der Signale, welche von der UHF-Antenne erfasst werden, deutlich besser sein als von herkömmlich verwendeten Barriere-Sensoren. Speziell gefertigte UHF-Sensoren können mechanisch passgenau für die vorhandenen Eingussöffnungen ausgelegt werden. Die Antenne des Sensors kann auf diese Anbausituation abgestimmt werden. Der metallische Ring des Flansches kann auch als Abschirmung gegen äußere elektrische Störungen dienen.

## Patentansprüche

1. Verbindungsstruktur (13) zum Verbinden zweier Anlagenteile (3, 5) einer gasisolierten Schaltanlage (1), aufweisend:
einen metallischen Flansch-Ring (17);
eine Gießharzeingussöffnung (19) in dem Flansch-Ring (17); und
einen UHF-Sensor (23) mit UHF-Antenne (22, 24), der bei der Gießharzeingussöffnung montiert ist,
**dadurch gekennzeichnet, dass**
der UHF-Sensor (23) einen Montagabschnitt (26) aufweist, um ihn an dem Flansch-Ring zu montieren, und einen Schließabschnitt (20) aufweist, um die Gießharzeingussöffnung zu verschließen,
wobei die UHF-Antenne (22, 24) an dem Schließabschnitt (20) angebracht ist,
der Schließabschnitt (20) des UHF-Sensors (23) an der Außenseite einen elektrischen Anschluss (33) aufweist,
die UHF-Antenne (22, 24) an einem radial inneren Ende eine Sensorelektrode (24) aufweist, welche sensitiv für elektromagnetische Wellen ist, und
die Sensorelektrode durch einen Leiter (22), insbesondere durch eine leitfähige Achse (22), mit dem elektrischen Anschluss (33) verbunden ist.

2. Verbindungsstruktur gemäß dem vorangehenden Anspruch, wobei die UHF-Antenne (23) derart montiert ist, dass innerhalb des Flansch-Ringes (17) vorhandene elektromagnetische Wellen erfassbar sind.

3. Verbindungsstruktur gemäß einem der vorangehenden Ansprüche, wobei die Gießharzeingussöffnung (19) durch eine Mantelfläche (27) des Flansch-Rings (17) führt.

4. Verbindungsstruktur gemäß einem der vorangehenden Ansprüche, ferner aufweisend:
ein, insbesondere ausgehärtetes, Gießharzmaterial (25) innerhalb des Flansch-Ringes (17),
wobei die UHF-Antenne (22, 24) derart montiert ist, dass sie im Kontakt mit dem Gießharzmaterial (25) ist.

5. Verbindungsstruktur gemäß dem vorangehenden Anspruch, ferner aufweisend:
mindestens eine innerhalb des Flansch-Ringes vom dem Gießharzmaterial umgebene Verbindungselektrode (41), mittels deren ein erster Leiter in einem ersten Anlagenteil (3) der gasisolierten Schaltanlage mit einem zweiten Leiter in einem zweiten Anlagenteil (5) der gasisolierten Schaltanlage verbindbar ist.

6. Verbindungsstruktur gemäß einem der vorangehenden Ansprüche, wobei die UHF-Antenne den Leiter (22) aufweist, durch den ein erfasstes Antennensignal nach außen abführbar ist.

7. Verbindungsstruktur gemäß einem der vorangehenden Ansprüche, wobei der elektrische Anschluss mit der UHF-Antenne (22, 24) elektrisch verbunden ist.

8. Verbindungsstruktur gemäß einem der vorangehenden Ansprüche, wobei der Schließabschnitt (20) und/oder ein die Gießharzeingussöffnung begrenzender Rand des Flansch-Ringes eine Dichtung (35) aufweist.

9. Verbindungsstruktur gemäß einem der vorangehenden Ansprüche, wobei der Flansch-Ring (17) im Wesentlichen kreiszylinderförmig ist.

10. Verbindungsstruktur gemäß einem der vorangehenden Ansprüche, wobei der Flansch-Ring (17) Löcher (37) entlang eines Umfanges (39) aufweist, um an jeder der beiden Stirnseiten ein jeweiliges Anlagenteil der gasisolierten Schaltanlage mittels Schrauben und/oder Bolzen anbringen zu können, wobei die Anbringung insbesondere gasdicht erfolgt.

11. Verbindungsstruktur gemäß einem der vorangehenden Ansprüche, wobei die UHF-Antenne (22, 24) zum Empfang einer elektromagnetischen Welle ausgelöst durch Teilentladung insbesondere mit Frequenz zwischen 100 MHz und 2 GHz, ausgelegt ist.

12. Gasisolierte Schaltanlage (1), aufweisend:
ein erstes Anlagenteil (3) und ein zweites Anlagenteil (5);
und eine Verbindungsstruktur (13) gemäß einem der vorangehenden Ansprüche, die an einer ersten Stirnseite mit dem ersten Anlagenteil und an einer zweiten Stirnseite mit dem zweiten Anlagenteil verbunden ist.

13. Verfahren eines Herstellens und/oder Nachrüstens einer Verbindungsstruktur (13) zum Verbinden zweier Anlagenteile (3, 5) einer gasisolierten Schaltanlage (1), wobei die Verbindungsstruktur (13) gemäß einem der Ansprüche 1 bis 11 ausgestaltet ist, aufweisend:
Montieren eines UHF-Sensors (23) mit einer UHF-Antenne (22, 24) bei einer Gießharzeingussöffnung (19) eines metallischen Flansch-Ringes (17) der Verbindungsstruktur (13).

14. Verfahren eines Überwachens einer gasisolierten Schaltanlage (1) mittels einer Verbindungsstruktur (13) gemäß einem der Ansprüche 1 bis 11, aufweisend:
Verwenden eines bei einer Gießharzeingussöffnung (19) eines metallischen Flansch-Ringes (17) der zwei Anlagenteile (3, 5) der gasisolierten Schaltanlage (1) verbindenden Verbindungsstruktur (13) montierten UHF-Sensors (23);
Erfassen einer innerhalb der gasisolierten Schaltanlage (1) erzeugten elektromagnetischen Welle mittels des UHF-Sensors (23).

## Claims

1. Connecting structure (13) for connecting two installation parts (3, 5) of a gas-insulated switchgear installation (1), comprising:
a metallic flange ring (17);
a casting resin pouring opening (19) in the flange ring (17); and
a UHF sensor (23) having a UHF antenna (22, 24), the UHF sensor being fitted at the casting resin pouring opening,
**characterized in that**
the UHF sensor (23) has a fitting portion (26) for being fitted to the flange ring and a closing portion (20) for closing the casting resin pouring opening,
wherein the UHF antenna (22, 24) is attached to the closing portion (20),
the closing portion (20) of the UHF sensor (23) has an electrical connection (33) on the outside,
the UHF antenna (22, 24) has a sensor electrode (24), which is sensitive to electromagnetic waves, at a radially inner end, and the sensor electrode is connected to the electrical connection (33) by a conductor (22), in particular by a conductive shaft (22).

2. Connecting structure according to the preceding claim, wherein the UHF antenna (23) is fitted in such a way that electromagnetic waves that are present within the flange ring (17) can be detected.

3. Connecting structure according to either of the preceding claims, wherein the casting resin pouring opening (19) passes through a lateral surface (27) of the flange ring (17).

4. Connecting structure according to one of the preceding claims, further comprising:
an, in particular cured, casting resin material (25) within the flange ring (17),
wherein the UHF antenna (22, 24) is fitted in such a way that it is in contact with the casting resin material (25).

5. Connecting structure according to the preceding claim, further comprising:
at least one connecting electrode (41) which is surrounded by the casting resin material within the flange ring and by means of which a first conductor in a first installation part (3) of the gas-insulated switchgear installation can be connected to a second conductor in a second installation part (5) of the gas-insulated switchgear installation.

6. Connecting structure according to any of the preceding claims, wherein the UHF antenna has the conductor (22), by way of which a detected antenna signal can be output to the outside.

7. Connecting structure according to any of the preceding claims, wherein the electrical connection is electrically connected to the UHF antenna (22, 24).

8. Connecting structure according to any of the preceding claims, wherein the closing portion (20) and/or an edge of the flange ring, the edge delimiting the casting resin pouring opening, has a seal (35).

9. Connecting structure according to any of the preceding claims, wherein the flange ring (17) is substantially circularcylindrical.

10. Connecting structure according to any of the preceding claims, wherein the flange ring (17) has holes (37) along a circumference (39), in order to be able to attach a respective installation part of the gas-insulated switchgear installation to each of the two end sides by means of screws and/or pins, wherein the attachment is performed in a gas-tight manner in particular.

11. Connecting structure according to any of the preceding claims, wherein the UHF antenna (22, 24) is designed for receiving an electromagnetic wave triggered by partial discharge in particular at a frequency of between 100 MHz and 2 GHz.

12. Gas-insulated switchgear installation (1), comprising:
a first installation part (3) and a second installation part (5);
and a connecting structure (13) according to any of the preceding claims, which is connected to the first installation part at a first end side and to the second installation part at a second end side.

13. Method of producing and/or retrofitting a connecting structure (13) for connecting two installation parts (3, 5) of a gas-insulated switchgear installation (1), wherein the connecting structure (13) is designed according to any of Claims 1 to 11, comprising:
fitting a UHF sensor (23) having a UHF antenna (22, 24) at a casting resin pouring opening (19) of a metallic flange ring (17) of the connecting structure (13).

14. Method of monitoring a gas-insulated switchgear installation (1) by means of a connecting structure (13) according to any of Claims 1 to 11, comprising:
using a UHF sensor (23) which is fitted at a casting resin pouring opening (19) of a metallic flange ring (17) of the connecting structure (13), which connects two installation parts (3, 5) of the gas-insulated switchgear installation (1);
detecting an electromagnetic wave, which is produced within the gas-insulated switchgear installation (1), by means of the UHF sensor (23).

## Revendications

1. Structure (13) de connexion pour la connexion de deux parties (3, 5) d'un appareillage (1) de coupure à isolation par du gaz, comportant :
un anneau-bride (17) métallique ;
une ouverture (19) de coulée d'une résine de coulée dans l'anneau-bride (17) ; et
un capteur (23) UHF ayant une antenne (22, 24) UHF, qui est montée dans l'ouverture de coulée d'une résine de coulée,
**caractérisée en ce que**
le capteur (23) UHF a une partie (26) de montage pour le monter sur l'anneau-bride et a une partie (20) de fermeture pour fermer l'ouverture de coulée d'une résine de coulée,
dans laquelle l'antenne (22, 24) UHF est montée sur la partie (20) de fermeture,
la partie (20) de fermeture du capteur (23) UHF a, du côté extérieur, une borne (33) électrique,
l'antenne (22, 24) UHF a, à un extrémité intérieure radialement, une électrode (24) de capteur, qui est sensible à des ondes électromagnétiques, et
l'électrode de capteur est connectée à la borne (33) électrique par un conducteur (22), en particulier par un axe (22) conducteur.

2. Structure de connexion suivant la revendication précédente, dans laquelle l'antenne (23) UHF est montée de manière à pouvoir détecter des ondes électromagnétiques présentes dans l'anneau-bride (17).

3. Structure de connexion suivant l'une des revendications précédentes, dans laquelle l'ouverture (19) de coulée d'une résine de coulée traverse une surface (27) latérale de l'anneau-bride (17) .

4. Structure de connexion suivant l'une des revendications précédentes, comportant en outre :
une matière (25) de résine de coulée, en particulier durcie dans l'anneau-bride (17),
dans laquelle l'antenne (22, 24) UHF est montée de manière à être contact avec la matière (25) de résine de coulée.

5. Structure de connexion suivant la revendication précédente, comportant en outre :
au moins une électrode (41) de connexion, qui est entourée, à l'intérieur de l'anneau-bride, de matière de résine de coulée et au moyen de laquelle un premier conducteur, dans une première partie (3) d'appareillage de coupure à isolation par du gaz, peut être connecté à un deuxième conducteur, dans une deuxième partie (5) de l'appareillage de coupure à isolation par du gaz.

6. Structure de connexion suivant l'une des revendications précédentes, dans laquelle l'antenne UHF comporte le conducteur (22), par lequel le signal d'antenne détecté peut être envoyé à l'extérieur.

7. Structure de connexion suivant l'une des revendications précédentes, dans laquelle la borne électrique est connectée électriquement à l'antenne (22, 24) UHF.

8. Structure de connexion suivant l'une des revendications précédentes, dans laquelle la partie (20) de fermeture et/ou un bord, délimitant l'ouverture de coulée d'une résine de coulée, de l'anneau-bride a une garniture (35) d'étanchéité.

9. Structure de connexion suivant l'une des revendications précédentes, dans laquelle l'anneau-bride (17) est de forme sensiblement cylindrique de section transversale circulaire.

10. Structure de connexion suivant l'une des revendications précédentes, dans laquelle l'anneau-bride (17) a des trous (37) le long d'un pourtour (39), afin de pouvoir monter, sur chacune des deux faces frontales, une partie respective de l'appareillage de coupure à isolation par du gaz au moyen de vis et/ou de boulons, dans laquelle le montage s'effectue d'une manière étanche au gaz.

11. Structure de connexion suivant l'une des revendications précédentes, dans laquelle l'antenne (22, 24) UHF est conçue pour la réception d'une onde électromagnétique déclenchée par une décharge partielle, en particulier d'une fréquence comprise entre 100 MHz et 2 GHz.

12. Appareillage (1) de coupure à isolation par du gaz, comportant :
une première partie (3) de l'appareillage et une deuxième partie (5) de l'appareillage ;
et une structure (13) de connexion suivant l'une des revendications précédentes, qui est connectée, à un premier côté frontal, à la première partie de l'appareillage et, à un deuxième côté frontal, à la deuxième partie de l'appareillage.

13. Procédé de fabrication et/ou rattrapage d'une structure (13) de connexion pour la connexion de deux parties (3, 5) d'un appareillage (1) de coupure à isolation par du gaz, dans lequel la structure (13) de connexion est conformée suivant l'une des revendications 1 à 11, comportant :
montage d'un capteur (23) UFH ayant une antenne (22, 24) UHF à une ouverture (19) de coulée d'une résine de coulée d'un anneau-bride (17) métallique de la structure (13) de connexion.

14. Procédé de contrôle d'un appareillage (1) de coupure à isolation par du gaz au moyen d'une structure (13) de connexion suivant l'une des revendications 1 à 11, comportant :
utilisation d'un capteur (23) UHF à une ouverture (19) de coulée d'une résine de coulée d'un anneau-bride (17) métallique d'une structure (13) de connexion reliant les deux parties (3, 5) de l'appareillage (1) de coupure à isolation par du gaz ;
détection au moyen du capteur (23) UHF d'une onde électromagnétique produite dans l'appareillage (1) de coupure à isolation par du gaz.
